# EUROPEAN PATENT APPLICATION

(11) **EP 0 825 610 A1**
(43) Date of publication of application: **25.02.1998**
(21) Application number: 96113200.8
(22) Date of filing: 16.08.1996
(51) Int. Cl.: G11C 7/00

(54) **Memory circuit**

(71) Applicant: TEXAS INSTRUMENTS DEUTSCHLAND GMBH, 85356 Freising (DE)
(72) Inventor: Skowronek, Ulrich, 80809 München (DE); Imondi, Giuliano, 02100 Rieti (IT)
(74) Representative: Schwepfinger, Karl-Heinz, Dipl.-Ing.

(57) **Abstract**

A memory circuit (10) for storing data words in a format having a predetermined number of data bits comprises an external input port (14) and an external output port (16) as well as control inputs (18) for receiving control signals for reading and writing of said data words, and a memory core (20) including a core data input (20) and a core data output (24), each having a number of terminals corresponding to the predetermined number of data bits. Between the memory input port (14) and the core data input (22) an input reformatting unit (26) is inserted which can be controlled so that it reformats data words applied to the external input port (14) in at least one format having a number of data bits different from the predetermined number to data words having the format with the predetermined number of data bits and applies these reformatted data words to the core data input (22). Between the core data output (24) and the external output port (16) an output reformatting unit (28) is inserted which performs a reformatting operation opposite to that of the input reformatting unit (26). A control unit (30) sets the reformatting mode of the reformatting units (26, 28) in dependence upon the format of the data words to be applied to the external input port (14) and under the control of a combination and or sequence of control signals assigned to this format and applied to the control inputs (18). Use: Storage of luminance and chrominance components of video signals appearing as 8bit-wide, 9bit-wide or 12bit-wide data words.

## Description

The invention relates to a memory circuit for storing data words in a format having a predetermined number of data bits, said memory circuit comprising an external input port and an external output port as well as control inputs for receiving control signals for reading and writing of said data words, and a memory core including a core data input and a core data output, each having a number of terminals corresponding to the predetermined number of data bits.

Many modern TV sets contain modules which perform digital image processing on the data received by the tuner. Examples of such digital image processing are 100Hz field rate up-conversion or PALplus decoding with image improvements by virtue of the additional data contained within PALplus signal streams.

Almost all commercially available TV sets with digital video processing modules for 100Hz or PALplus digitize the incoming analog signals with a colour sub-sampling factor of 4 to 1, i.e. the 2 chrominance components of the signal, Cr and Cb, are sampled at only one-fourth the rate which is used for sampling the luminance component Y. This particular colour sub-sampling scheme is usually called 4:1:1, denoting the sampling ratios for Y:Cr:Cb.

4:1:1 colour sub-sampling is acceptable for TV signals derived from natural images, because the frequency spectrum of the colour information contained therein is less than one-fourth of the spectrum of the luminance component. In professional environments, however, 4:2:2 colour sub-sampling is usually employed. Here the components Cr and Cb are sampled at one-half the rate of the luminance component, or twice as fast as in the 4:1:1 scheme. The 4:2:2 sub-sampling doubles colour fidelity of the digitized signal, a measure which is necessary for many video productions, because in the studio or production environment, often non-natural information signals, such as those required for chroma keying, are superimposed onto the natural image material, leading to a higher freqency spectrum of the colour components Cr and Cb of the resulting signal.

Another application area for 4:2:2 colour sub-sampling is multi-media, where signals derived from natural TV images are intermixed with signals generated artificially by computer calculations. Here again the colour frequency spectrum from the resulting signals can be significantly wider, necessitating the higher colour fidelity of 4:2:2 sub-sampling.

To accomplish digital video processing, such as 100Hz up-conversion or PALplus decoding with image enhancement, one or several field memories are required, the exact number depending on the complexity of the processing which is utilized. Almost all such digital processing modules built into commercially available TV sets today employ 4:1:1 colour sub-sampling. An ideal field memory for these tasks has a capacity of about 3Mb (= Megabits) and a data width of 12 bits. Field memory TMS4C2973 of Texas Instruments Incorporated is one example of such a field memory. In the memory core of this field memory, the data words are stored as 12bit data words. Since the luminance and chrominance components are data words having 8 bits each, the 12bit words are suitable for being used in the 4:1:1 sub-sampling scheme. Each 12bit data word in the memory core contains an 8bit luminance component, 2 bits of chrominance component Cr, and 2 bits of chrominance component Cb. Four 12bit words provide the storage capacity for four luminance components and for one chrominance component Cr and one chrominance component Cb.

It is expected that future TV sets with digital processing features will have to handle multi-media signals to a higher and higher extent as a function of years of manufacture. TV makers who design future sets are therefore looking more and more for memories capable of storing video signals sub-sampled according to the 4:2:2: scheme. Such memories require a higher storage capacity of about 4Mb, and they are generally configured 16bit-wide. With this configuration, each 16bit storage location in the memory contains one 8bit luminance data word and one of the two 8bit chrominance data words Cr or Cb. According to the 4:2:2 colour sub-sampling scheme, each set of two luminance data words is accompanied by one chrominance component Cr and one chrominance component Cb.

Recently another requirement for future high signal fidelity memories for digital video has arisen. More and more TV makers find a data width of 8 bits for the luminance and chrominance components insufficient, and like to use instead field memories which can accommodate an 9-bit data width. If data width were increased in this manner, a digital TV module with 4:2:2 sub-sampling would require 18bit-wide memories and 18bit-wide data paths which would increase the cost of such memories substantially.

The above explanations show that there is a need for a field memory suitable for operating in a 4:1:1 colour sub-sampling environment and also in a 4:2:2 colour sub-sampling environment, which can support data streams 12 bits wide, 8 bits wide or 9 bits wide, without increasing memory costs relative to a 12bit-only memory.

To achieve this object, the memory circuit according to the invention is characterized in that between the external input port and the core data input an input reformatting unit is inserted which can be controlled so that it reformats data words applied to the external input port in at least one format having a number of data bits different from the predetermined number, to data words having the format with the predetermined number of data bits, and applies these reformatted data words to the core data input, that between the core data output of the memory core and the external output port an output reformatting unit is inserted which reformats the data words delivered by the core data output of the memory core in a manner opposite to that of the input reformatting unit to the format of the data words at the external input port, and applies these reformatted data words to the external output port, and that a control unit is provided which sets the reformatting mode of the reformatting units in dependence upon the format of the data words to be applied to the external input port and under the control of a combination and/or sequence of control signals assigned to this format and applied to the control inputs.

A memory circuit of this type is plug-in compatible with today's field memories of the type mentioned above, for instance the TMS4C2973 of Texas Instruments Incorporated, for drop-in replacement. By adding the reformatting units the memory circuit supports 4:2:2 colour sub-sampling in addition to the 4:1:1 colour sub-sampling, and it supports 8bit-data width and 9bit-data width for each of the three video components Y, Cr, Cb. Depending on the desired use, the memory circuit can be switched to the necessary mode of operation by applying corresponding control signals to the existing control inputs of the circuit.

Other objects, features and advantages of the invention are apparent in the following specification and accompanying drawings, wherein
- Figure 1 is a block diagram of the memory circuit according to a preferred embodiment of the invention;
- Figure 2 is a more detailed block diagram of the input reformatting unit;
- Figure 3 is a more detailed block diagram of the output reformatting unit;
- Figure 4a and Figure 4b depict embodiments of an 8 to 12 bit reformatter and a 9 to 12 bit reformatter, respectively; and
- Figure 5 is a time diagram suitable for explaining a way of controlling the operating mode of the memory circuit according to the invention.

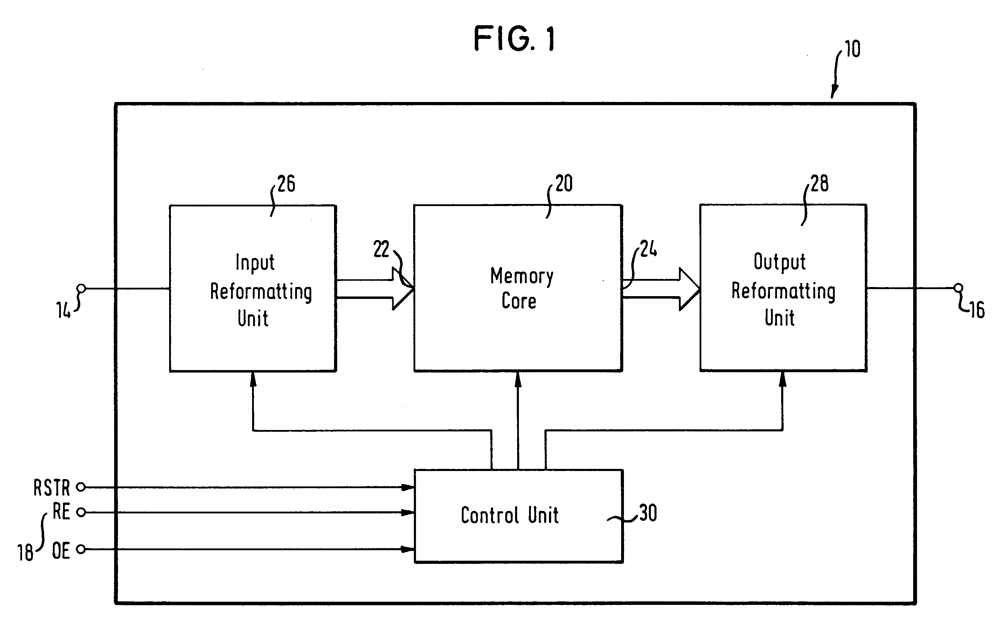

In Figure 1 a block diagram of a memory cicuit 10 according to the invention is shown. The memory circuit has an external input port 14 and an external output port 16. The externalinput and output ports each have 12 terminals for receiving and delivering data words having up to 12 bits. Additionally, control terminals 18 are provided for applying control signals necessary for controlling read and write operations of the memory circuit.

Memory circuits further include a memory core 20 which includes memory cells for storing the necessary number of data words. The memory core 20 is suitable for storing 12bit data words. Therefore, it has a core data input 22 which receives 12bit-wide data words and it has a core data output delivering 12bit-wide data words. Both the core data input 22 and the data output 24 has 12 terminals for receiving and delivering 12bit-wide data words.

Between the external input port 14 and the core data input 22, an input reformatting unit 26 is inserted suitable for reformatting the data words received at external input port 14 if the format of these data words differs from the 12bit-wide data word format necessary for applying to core data input 22 of memory core 20. Further, an output reformatting unit 28 is inserted between core data output 24 and external output port 16. This output reformatting unit performs a data reformatting opposite to that of the input reformatting unit 26.

A control unit 30 is provided for controlling both the read and write operations in memory core 20 and the reformatting modes of reformatting units 26 and 28.

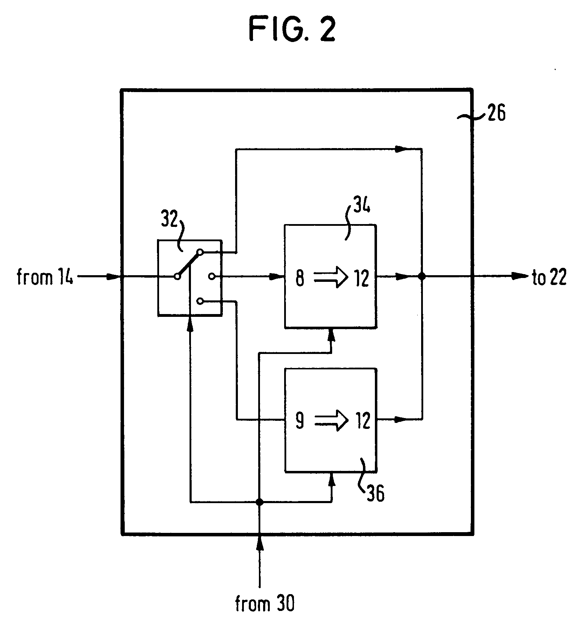

In Figure 2 a more detailed diagram of input reformatting unit 26 is shown. This diagram does not show the actual structure, but has the purpose of explaining the operating principle of this unit.

The input reformatting unit 26 receives from external input port 14 data words containing 8, 9 or 12 bits. By means of a switch 32, these data words can be directed either directly or via an 8/12-reformatter 34 or a 9/12-reformatter 36 to core data input 22 of memory core 20. Switch 32 is controlled by a control signal generated by control unit 30 in dependence upon the width of the data words applied to external input port 14.

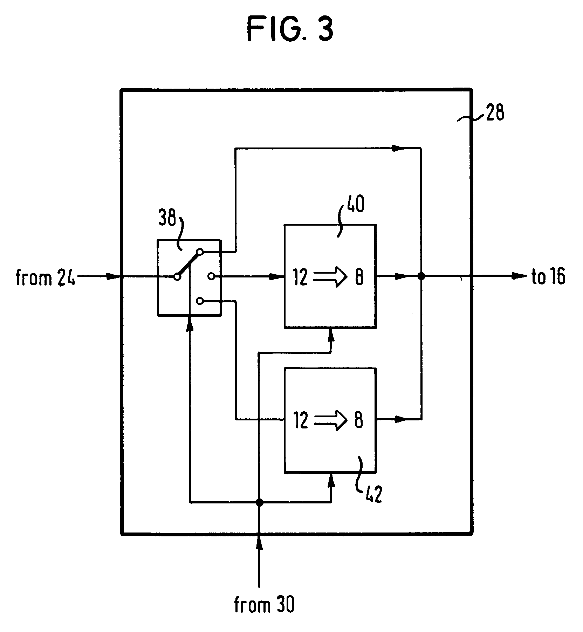

A more detailed diagram of output reformatting unit 28 is shown in Figure 3. As shown therein, 12bit data words furnished by memory core 20 at core data output 24 are applied to a switch 38 which, in dependence upon its position, transfers these data words either directly or via a 12/8-reformatter 40 or a 12/9-reformatter 42 the external output port 16. The position of switch 38 is set by the same control signal from control unit 30 as reformatting unit 26.

If, for example, 8bit data words are received at external input port 14, control unit 30 receives, in a manner to be explained below, information on the width of the data word at input 14 and generates a control signal which is applied to switch 32 and to switch 38. This control signal sets these switches to the middle position, so that the input data words are applied to the memory core via 8/12-reformatter 34 and the data words furnished by memory core 20 are transferred to external output port 16 via 12/8-reformatter 40. This means that both at external input port 14 and at external output port 16 8bit data words appear, whereas memory core 20 both receives and delivers 12bit data words.

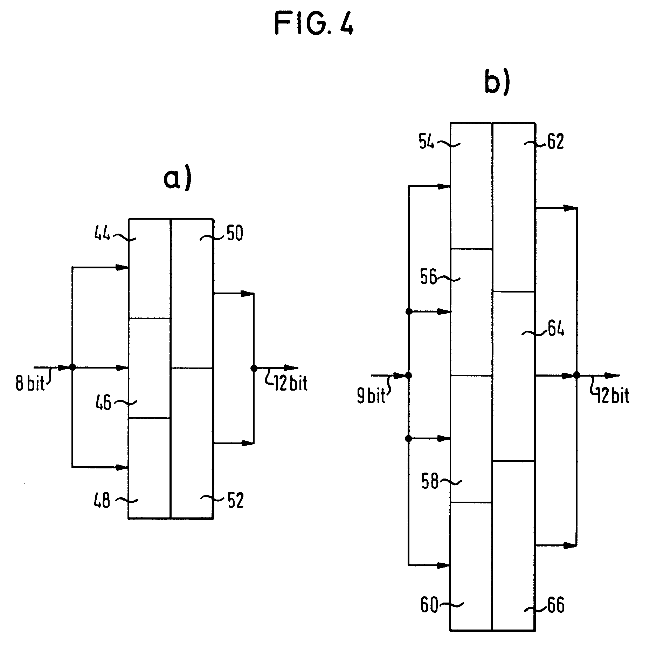

In Figure 4a a schematic diagram of 8/12 reformatter 34 is shown. This reformatter contains three registers 44, 46, 48, each having eight stages for receiving 8 bits of an 8bit-wide data word. Three consecutive 8bit-wide data words are loaded into these registers 44 to 48. From these registers the data words are loaded into two 12bit-wide registers 50 and 52. From these registers 50 and 52 the data words can be applied to core data input 22 of memory core 20. Loading and unloading of registers 44, 46, 48, 50 and 52 is controlled by control unit 30.

Figure 4b shows a schematic diagram of 9/12 reformatter 36. This reformatter includes 4 registers 54, 56, 58 and 60, each having nine stages for receiving 9bit data words. Four consecutive 9bit-wide data words are loaded into these registers 54, 56, 58 and 60. The contents of these registers is loaded into three registers 62, 64 and 66, each having twelve stages for receiving 12bit-wide data words. These 12bit-wide data words can then be applied to core data input 22 of memory core 20. Loading and unloading of these registers is also controlled by control signals from control unit 30.

Instead of using 12bit-wide registers 50, 52 or 62, 64, 66 for transferring 12bit-wide data words to memory core 20, it is also possible to derive the 12bit-wide data words directly from outputs of registers 44, 46, 48 or 54, 56, 58, 60, so that the 12bit-wide registers can be omitted.

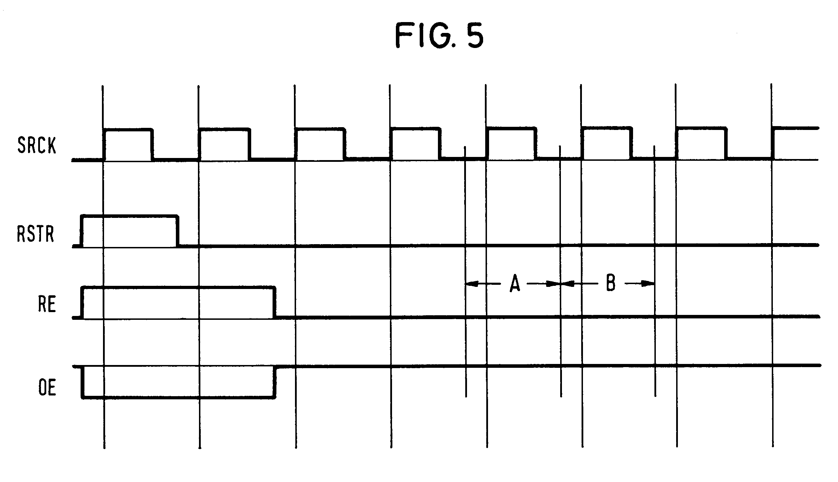

Reference is now made to Figure 5 showing a timing diagram suitable for explaining the manner in which the operating mode of memory 10 is controlled. The first line of this diagram shows a clock signal SRCK which is the serial read clock used as a time reference for all control signals. The next lines show a reset read signal RSTR, a read enable signal RE and an output enable signal OE. These signals are control signals used in connection with the above-mentioned memory circuit TMS4C2973 mentioned above. Since no extra pin is available for switching the operating mode of memory 10, combinations or sequences of the aforementioned control signals are used for mode switching which do not occur in the usual manner of controlling the memory.

In order to initiate mode switching, a particular sequence of logic states on control input terminals RE and OE must be applied, during the 4 SRCK cycles which follow the control input RSTR going to a high logic level. During the first 2 SRCK cycles, RE must be high and OE must be low, and during the next 2 SRCK cycles, RE must be low and OE must be high. Whenever this signal combination appears, control circuit 30 is informed that mode switching is desired. Of course, any other combination of control signals not occurring in the usual manner of controlling the memory can be used for initiating mode switching.

If during time period A, the period following the second low level period of RE, the read enable signal RE once again goes high, memory circuit 10 is switched to a mode suitable for receiving 8bit-wide data words at external input port 14 and for furnishing 8bit-wide data words at memory output port 16. If read enable RE goes high during time period B, the period following period A, memory circuit 10 is switched to the 9bit mode, i.e. the mode suitable for receiving 9bit-wide data words at external input port 14 and furnishing 9bit-wide data words at external output port 16. Any other combination of logic states at time period A and/or time period B can be chosen also.

To avoid switching the memory to an inappropriate mode, for instance by electrical noise generated during time periods A or B, resulting in totally corrupted display images, the memory can be reset to the 12bit mode at every occurrence of the reset read signal RSTR, unless the before explained sequence of signals appears and results in switching to the 8bit or 9bit mode.

The memory circuit explained above is suitable for storing fields in accordance with the 4:1:1 colour sub-sampling scheme or in the 4:2:2 colour sub-sampling scheme with 8, 9 or 12bit-wide data words. It does not make use of any additional pin so that it is pin compatible to presently used field memories, such as TMS4C2973. The necessary increase in memory capacity of memory core 20 to allow storage of more data necessitated by 4:2:2 colour sub-sampling or by 9bit-wide input data and the addition of the reformatting units do not have any substantial impact on the overall costs of the memory circuit.

## Claims

1. Memory circuit for storing data words in a format having a predetermined number of data bits, said memory circuit (10) comprising an external input port (14) and an external output port (16) as well as control inputs (18) for receiving control signals for reading and writing of said data words, and a memory core (20) including a core data input (22) and a core data output (24), each having a number of terminals corresponding to the predetermined number of data bits, characterized in that between the external input port (14) and a core data input (22) an input reformatting unit (26) is inserted which can be controlled so that it reformats data words applied to the external input port in at least one format having a number of data bits different from the predetermined number to data words having the format with the predetermined number of data bits and applies these reformatted data words to the core data input (22), that between the core data output (24) of the memory core (20) and external output port (16) an output reformatting unit (28) is inserted which reformats the data words delivered by the core data output (24) of the memory core (20) in a manner opposite to that of the input reformatting unit (26) to the format of the data words at the external input port, and applies these reformatted data words to the external output port, and that a control unit (30) is provided which sets the reformatting mode of the reformatting units (26, 28) in dependence upon the format of the data words to be applied to the external input port (14) and under the control of a combination and/or sequence of control signals (RSTR, RE, OE) assigned to this format and applied to the control inputs (18).

2. Memory circuit according to claim 1 characterized in that the data words applied to the external input port (14) contain luminance and chrominance information of a video signal, that said memory core (20) is organised for storing 12bit-wide data words, that said data words are applied to the external input port (14) as 8bit-wide data words, as 9bit-wide data words or as 12bit-wide-data words, that said input reformatting unit (26) reformats the 8bit-wide and 9bit-wide data words to 12bit-wide data words, and that said output reformatting unit (28) reformats the data words delivered by the core data output (24) of the memory core (20) to the same format as the data words applied to the external input port (14).
